(19) **Europäisches Patentamt**

**European Patent Office**

**Office européen des brevets**

(11) **EP 0 599 414 B1**

(12) **EUROPEAN PATENT SPECIFICATION**

(45) Date of publication and mention
of the grant of the patent:
**02.08.2000 Bulletin 2000/31**

(51) Int. Cl.$^7$: **H04B 1/30**, H03J 7/02

(21) Application number: **93203239.4**

(22) Date of filing: **18.11.1993**

(54) **A direct conversion receiver**

Direktumsetzempfänger

Récepteur à conversion directe

(84) Designated Contracting States:
**CH DE FR GB IT LI**

(30) Priority: **26.11.1992 EP 92203653**

(43) Date of publication of application:
**01.06.1994 Bulletin 1994/22**

(73) Proprietor:
**Koninklijke Philips Electronics N.V.
5621 BA Eindhoven (NL)**

(72) Inventor:
**Mohindra, Rishi,
c/o INT. OCTROOIBUREAU B.V.
NL-5656 AA Eindhoven (NL)**

(74) Representative:
**Mak, Theodorus Nicolaas et al
International Octrooibureau B.V.,
Prof. Holstlaan 6
5656 AA Eindhoven (NL)**

(56) References cited:
**EP-A- 0 298 484          GB-A- 2 180 419**

**Description**

The present invention relates to a direct conversion receiver comprising a local frequency generating arrangement which is coupled to a pair of quadrature related mixers for mixing down an rf input signal to quadrature related signals, and a.f.c. means for providing a control signal for the local frequency generating arrangement, the a.f.c. means, which are coupled to quadrature paths, comprising an offset frequency detector for determining a signal as the control signal, of which an average value is proportional to a frequency offset of the local frequency generating arrangement with respect to the rf input signal, whereby the offset frequency detector comprises a series arrangement of a phase shifting arrangement and a multiplication arrangement in a quadrature path. Such direct conversion receivers can be digital paging receivers or transceivers using an FSK (Frequency Shift Keying) modulation scheme, but also transceivers for cordless telephony or the like.

A direct conversion receiver of this kind is known from the European Patent EP 298 484 B1. In the known direct conversion receiver, which is an optical receiver, an a.f.c. (automatic frequency control) signal for a local oscillator with inherent correct polarity is derived from so-called I- and Q-channel receiver paths. For this purpose, a baseband I-channel signal is fed to an offset frequency detector, together with a quadrature related Q-channel signal. The offset frequency detector is a series arrangement of a phase shifting arrangement and a multiplication arrangement, whereby the I-channel signal is fed to an input of the multiplication arrangement, and the Q-channel signal is fed to another input of the multiplication arrangement via the phase shifting arrangement. An output signal of the offset frequency detector is fed to the local oscillator via a low pass filter. In the known receiver the control signal is a bipolar signal, which is subject to a relatively strong low frequency ripple component.

It is an object of the present invention to provide a direct conversion receiver having an improved performance, and imposing less demand upon signal averaging in the low pass loop filter.

To this end a direct conversion receiver according to the present invention is characterised in that the frequency detector comprises another series arrangement of a phase shifting arrangement and a multiplication arrangement in another quadrature path, and a subtracting arrangement for subtracting output signals of the multiplication arrangements, whereby inputs of the multiplication arrangements are cross-coupled to the quadrature paths, and other inputs of the multiplication arrangements, are coupled to the quadrature paths via the phase shifting arrangements. In the receiver according to the present invention the control signal comprises a considerable higher ripple frequency component as compared with the known receiver, thus a successive low pass filter for filtering of the control signal can have a much higher cut-off frequency, so that the a.f.c. loop has got a quicker response. This is advantageous for a quick frequency lock and also for scanning frequency channels. For an appropriate response the filter cut-off frequency should not become too low with respect to the ripple frequency of the control signal, i.e. a trade-off has to be made between a fast loop response and a clean a.f.c. signal. When using a direct conversion receiver according to the present invention e.g. as an FSK data paging receiver for high frequencies such as in the 900 MHz band, use of expensive temperature compensating schemes for compensating frequency drift of a crystal oscillator in such a receiver as is necessary in conventional paging receivers, is also avoided.

Although the phase shifting arrangement and the multiplication arrangement can be implemented by using analog circuits, in a simple embodiment the phase shifting arrangement is a shift register and the multiplication arrangement is an exclusive-OR. In such an embodiment, the phase shifting arrangement has a phase shift proportional to frequency, i.e. is a time delay arrangement.

An alternative embodiment of a direct conversion receiver according to the present invention comprises a microcontroller functionally implementing the series arrangements and the subtracting arrangement, and digital-to-analog conversion means and/or digital output means for providing the control signal. Such an embodiment is particularly advantageous if the direct conversion receiver comprises a microcontroller with digital I/O-channels and/or a digital-to-analog converter for other purposes, and such resources can be shared for implementing the present invention. The shared resources can be multiplexed, then.

In a further embodiment of a direct conversion receiver according to the present invention, the control signal is fed to the local oscillator via an analog or digital integrator or via an analog or digital low pass filter. Thus, the a.f.c. loop dynamics can be easily controlled. Using an integrator achieves a zero steady state response. The digital embodiment is particularly advantageous if microcontroller resources can be shared, as mentioned above.

For a.f.c. range extension, the direct conversion receiver according to the present invention comprises a data demodulation arrangement in parallel with the offset frequency detector for providing data from the quadrature related baseband signals, a data filter for providing filtered data, and an out-of-range decision arrangement coupled to the data filter via an averaging filter, whereby the decision arrangement controls a switching arrangement for switching an output signal of the offset frequency detector as the control signal, or the filtered data as the control signal. Such a range extension, e.g. in an FSK receiver, is necessary if the frequency of the local oscillator drifts close to or beyond the frequency deviation of the received r.f. FSK data signal. The out-of-range decision arrangement, which can be a window comparison arrangement, detects such an out-of-range condition, and the filtered data is taken as an a.f.c. control signal instead of an output signal of the offset frequency detector. Such an out-of-range detection is particularly effective if the number of ones and zeroes in the FSK signal is approximately equal, on the average. The out-of-range detection can also be a software-based decision arrangement implemented with a microcontroller, which checks data validity or other signal parameters like signal frequency for taking an out-of-range decision. In case of checking signal frequencies, checking a frequency of a product signal of the I and Q channels, i.e. checking a double frequency, more accurate measurement is achieved than checking the frequency of an I or Q channel alone. Checking data validity can be based on a valid CRC (Cyclic Redundancy Code), a BER (Bit Error Rate), or the like.

An embodiment of a direct conversion device according to the present invention comprises bandpass filters in the respective quadrature paths, wherein for a.f.c. out-of-range extension the bandpass filters are stopband filters stopping a band substantially from DC, or wherein for out-of-range extension the direct conversion receiver comprises highpass filters coupled to the quadrature paths, whereby the combined bandpass and highpass filters form stopband filters, and wherein the phase shifting arrangements have a non-linear shifting characteristic approaching a predetermined phase shift with increasing frequency. The stopband or frequency gap is chosen such that for a zero offset frequency, the received signal frequency just falls outside the gap, whereas for an offset beyond the frequency deviation of the input rf signal one of the FSK data "0" and "1" frequencies falls inside the gap. It is thus achieved that the gap suppresses a signal that would otherwise pull the a.f.c. into the wrong direction.

An embodiment of a direct conversion device according to the present invention comprises filters in the respective quadrature paths, wherein for a.f.c. out-of-range extension the phase shifting arrangements have a non-linear phase shifting characteristic changing from a first predetermined phase shift to a second predetermined phase shift with increasing baseband frequency around a predetermined baseband frequency (which could also be $\Delta f$, $\Delta f$ being a frequency deviation). Thus always a correct polarity a.f.c. signal is achieved. For a frequency offset beyond twice the frequency deviation both a correct polarity and non-reduced a.f.c. loop gain is achieved, whereas for a lower offset some a.f.c. loop gain reduction occurs.

The present invention will now be described, by way of example, with reference to the accompanying drawings, wherein

Fig. 1 schematically shows a direct conversion receiver according to the present invention,

Fig. 2 shows an embodiment of an offset frequency detector and out-of-range detection means according to the present invention,

Fig. 3 shows a window comparison arrangement as an out-of-range decision arrangement according to the present invention,

Fig. 4 shows effects on baseband frequencies for various frequency offsets,

Fig. 5A and 5B show digital output signals of a prior art offset frequency detector and an offset frequency detector according to the present invention, respectively,

Fig. 6 shows an average of a filtered data signal as a function of a frequency deviation of a local oscillator with respect to a carrier frequency of an FSK signal,

Fig. 7 shows a frequency characteristic of a filter in an embodiment of the present invention,

Fig. 8 shows a phase shifting characteristic in an embodiment of the present invention,

Fig. 9 shows an embodiment of a phase shifting arrangement of the present invention,

Fig. 10 shows a phase shifting characteristic in another embodiment of the present invention, and

Fig. 11 shows another embodiment of a phase shifting arrangement.

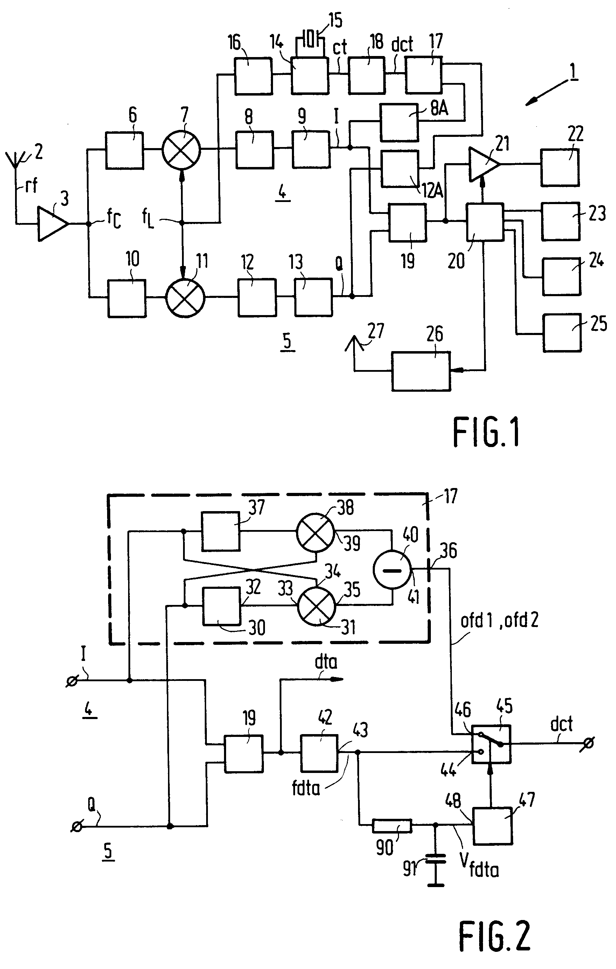

Figure 1 schematically shows a direct conversion receiver 1 according to the present invention. The direct conversion receiver 1, which can be a paging transceiver, comprises an antenna 2 for receiving an rf (radio frequency) input signal rf, which can be an rf FSK (Frequency Shift Keying) signal carrying FSK modulated digital signals. The rf input signal rf is fed to a low noise rf amplifier 3, which is coupled to quadrature paths 4 and 5, so-called I- and Q-channels, for mixing down the rf input signal rf to quadrature related baseband signals I and Q. The quadrature path 4 comprises a phase shifting device 6 causing a +45 degrees phase shift of the amplified rf signal. The phase shifting device 6 is coupled to a mixer 7 for mixing down the rf signal rf to the baseband signal I, an output of the mixer 7 being filtered and limited by means of a respective filter 8 and a limiter 9. Similarly, the quadrature path 5 comprises a phase shifting device 10 causing a -45 degrees phase shift of the amplified rf signal, a mixer 11, a filter 12, and a limiter 13 for achieving the baseband signal Q. The filters 8 and 12 are provided for limiting the noise bandwidth and for channel selectivity. By AC-coupling of the filters 8 and 12 to the mixers 7 and 11, DC-offset effects are avoided. The limiters 9 and 13 are provided for removing amplitude signal variations. The mixers 7 and 11 are further coupled to a local frequency generating arrangement, e.g. a crystal oscillator having a crystal 15 as a frequency determining element, via a frequency multiplication arrangement 16. The local frequency generating arrangement 14 can also be a more elaborate arrangement, e.g. a frequency synthesizer having a crystal oscillator for providing a reference frequency. Such frequency synthesizers can operate on the basis of a PLL (Phase Locked Loop). In a direct conversion receiver the mixing frequency, i.e. an output frequency $f_L$ of the multiplication arrangement 16, further denoted as oscillator frequency, is chosen such that baseband zero-intermediate frequency signals I and Q are obtained, for a fictitious carrier $f_C$. Instead of two phase shifting devices, with +45 degrees and - 45 degrees phase shifting, respectively, a single 90 degrees phase shifting device can be applied, for phase shifting the oscillator signal for one of mixer signals. E.g. for FSK modulated rf signals with a frequency deviation of +4 kHz and -4kHz around a 900 MHz carrier frequency $f_C$, the carrier not physically being present in the received rf input signal rf, representing logical "0" and logical "1" transmitted signals, the baseband signals I and Q are 4 kHz signals, though differing in phase, if $f_L = f_C$. In case of a frequency offset of the oscillator frequency $f_L$ with respect to the rf input signal rf, i.e. with respect to the carrier frequency $f_C$, the baseband signals I and Q have different frequencies. According to the present invention, the direct conversion receiver 1 comprises a.f.c. means coupled to the quadrature paths 4 and 5 comprising an offset frequency detector 17 for determining a signal dct as an a.f.c. control signal for the local oscillator 14, a DC (Direct Current) component of the signal dct being proportional to the frequency offset $f_L - f_C$, the offset frequency detector 17 compsing two series arrangements of a phase shifting arrangement and a multiplication arrangement and a subtracting or adding arrangement, to be described in detail in connection with figure 2. The signal dct practically is fed to the local oscillator 14 via a smoothing arrangement 18, being an analog or digital integrator, or an analog or digital low pass filter, i.e. an actual control signal ct is the smoothed signal dct. The signal dct can be an analog or digital signal, depending whether or not the quadrature paths comprise limiters. Poles and zeroes of the smoothing arrangement 18 or smoothing filter determine a.f.c. loop dynamics. From a practical point of view, a filter cut-off frequency could be in a range between a ripple frequency of the digital signal dct divided by 1000 and a frequency of the digital signal dct divided by 20, a trade-off being made between a noisy, but fast loop, and a slower, but more stable loop. A fast loop response is required for fast channel scanning or for fast locking. Thus, a higher ripple frequency allows for a better overall performance. The present invention achieves an a.f.c. control signal with an inherent correct polarity, obviating the need for multiplication with demodulated data, such as in other prior art receivers, e.g. as disclosed in GB 2 180 419. Furthermore, as compared with known receivers using crystal oscillators without applying an a.f.c. control signal thereto, no complicated temperature drift compensation schemes are necessary. E.g., a less than 2.8 ppm temperature drift or aging drift compensation in such known receivers in the 900 MHz band would be expensive or even impractical in paging receivers. The present invention allows for using crystals without temperature compensation. The offset frequency detector 17 can be implemented analogly or digitally. For obtaining demodulated data, the direct conversion receiver 1 comprises a demodulator 19 to which the baseband signals I and Q are fed. The demodulator 19 can be a lead-lag phase detector for demodulating FSK data. The demodulator is coupled to a microcontroller 20 with RAM and ROM memory and digital and/or analog I/O-interfaces. Such microcontrollers are well known in the art. For a paging transceivers, various output signals may be provided for such as a speech signal via an amplifier 21 and a speech reproducing device 22, an information message via a display unit 23, a audible tone signal via a bleeper 24, and a visual alert signal via an LED 25. In case of a paging transceiver, allowing for sending a return message transmission means 26 are provided for, which are controlled by the microcontroller 20, the transmission means being coupled to a transmitting aerial 27.

Fig. 2 shows an embodiment of the offset frequency detector 17 and out-of-range detection means according to the present invention, the same reference numerals having been used for corresponding features. In figure 2, unfiltered data dta are available at an output of the demodulator 19. In the prior art, the said EP 298 484, the offset frequency detector 17 comprises a series arrangement of a phase shifting arrangement 30 and a multiplication arrangement 31 in one quadrature path, e.g. the quadrature path 5 as shown in figure 1. In case of one series arrangement the baseband signal Q is fed to the phase shifting arrangement 30 of which an output 32 is coupled to a first input 33 of the multiplication arrangement 31. The baseband signal I is fed to a second input 34 of the multiplication arrangement 31, of which an output 35 forms an output signal ofd1 at an output 36 of the offset frequency detector 17. The baseband signals I and Q may also be interchanged. In case of series arrangements in both quadrature path as according to the present invention, the offset frequency detector 17 further comprises a phase shifting arrangement 37 and a multiplication arrangement 38, being coupled to the baseband signals I and Q as described, i.e. the series arrangements are cross-coupled to the baseband signals I and Q. The output 35 of the multipication arrangement 34 and an output 39 of the multiplication arrangement 38 are fed to a subtracting arrangement 40 for subtracting output signals of the multiplication arrangements 31 and 38. An output 41 of the subtracting arrangement 17 forms an output signal ofd2 at the output 36 of the offset frequency detector 17. The offset frequency detector 17 can be implemented digitally, the phase shifting arrangements 30 and 37 being clocked shift registers, and the multiplication arrangements 31 and 38 being exclusive-OR digital circuits. In case of a single series arrangement, as in the prior art frequency detector, the digital signal dct is a bipolar signal with varying pulsewidth, and in case of the frequency detector according to the present invention having a series arrangement in both quadrature paths together with a subtracting arrangement the digital signal dct is a unipolar signal of which the polarity depends of the sign of the offset frequency $f_L$-$f_C$. Also, the microcontroller 20 can functionally implement the series arrangements 30, 31 and 37, 38, and subtracting arrangement 40. By applying a well known microcontroller with digital I/O interfaces and digital-to-analog conversion means the a.f.c. signal ct can be fed immediately to the local oscillator 14.

For a.f.c. range-extension, the direct conversion receiver 1 comprises the data demodulation arrangement 19 which provides the demodulated data signal dta, and further a data filter 42 for filtering the demodulated data signal dta, which can be a filter as described in the European Patent Application No. 922021791.8 (PHN 14.107 EP-P), or another data filter. An output 43 of the data filter 42 is coupled to a first input 44 of a switching arrangement 45, the output 36 of the offset frequency detector 17 being coupled to a second input 46 of the switching arrangement 45. The switching arrangement 45, which is controlled by an out-of-range decision arrangement 47. An input 48 of the out-of-range decision arrangement 47 is coupled to the output 43 of the data filter 42. On the basis of an average value $V_{fdta}$ of the filtered data signal fdta, which is obtained by feeding the filtered data signal to an RC-filter e.g. comprising a resistor 90 and a capacitor 91, the decision arrangement 47 decides whether the oscillator frequency $f_L$ falls with a given frequency range around the carrier frequency $f_C$, or outside this given range. If the oscillator frequency $f_L$ falls within the given range, the offset frequency detector 17 provides the digital signal dct, whereas otherwise the filtered data signal fdta is used as the digital signal dct. The a.f.c. range-extension gives a better result, the more the condition is fulfilled that the number of ones in the received signal rf is equal to the number of zeroes in the signal rf, on the average. The out-of-range decision arrangement may also be a software-based arrangement, at least partially, being comprised within the controller 20. Then the decision can be based upon valid data, and or frequency measurement of the I signal or Q signal, or the product of the I signal and Q signal. A valid data decision can be based upon a valid CRC (Cyclic Redundancy Code, a BER (Bit Error Rate), or the like, or upon a frequency below a threshold frequency. Frequency measurements can be made with a frequency-to-to voltage converter <u>inter</u> <u>alia</u>.

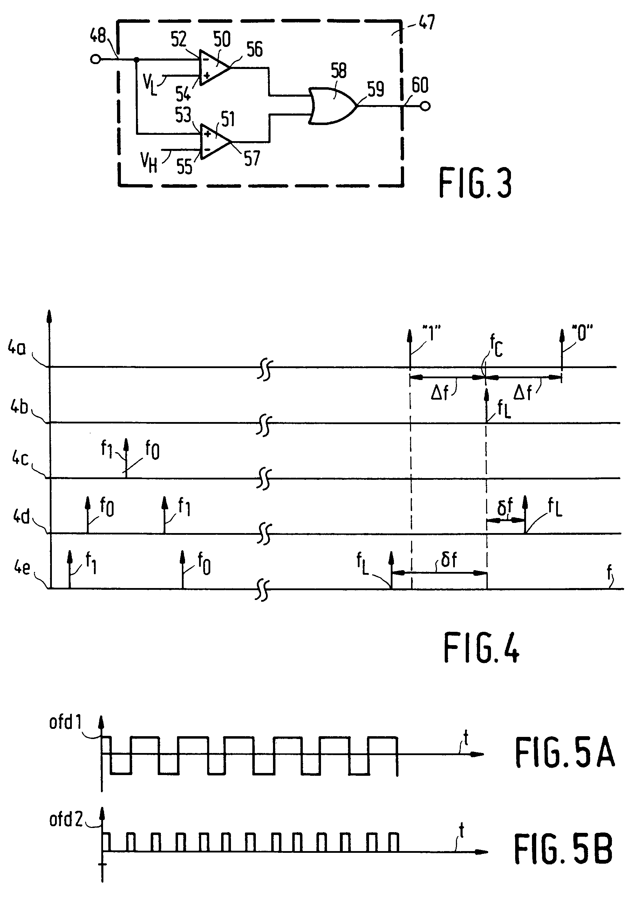

Fig. 3 shows a window comparison arrangement as an out-of-range decision arrangement 47 according to the present invention, comprising a first and a second comparator 50 and 51, a minus input 52 of the comparator 50 being coupled to a plus input 53 of the comparator 51, the coupled inputs 52 and 53 forming the input 48 of the arrangement 47. A low threshold signal $V_L$ is fed to a plus input 54 of the comparator 50, and a high threshold signal $V_H$ is fed to a minus input 55 of the comparator 51. Outputs 56 and 57 of the respective comparators 50 and 51 are coupled to an OR-gate of which an output 59 is coupled to an output 60 of the out-of-range decision arrangement 47. Within each of the comparators 50 and 51 a positive feedback can be applied for giving an hysteresis effect to the threshold signals $V_L$ and $V_H$.

For a further description of a first embodiment of the present invention, in relation to the prior art, figures 4 to 7 show various signals as a function of frequency or time.

Fig. 4 shows effects on baseband frequencies for various frequency offsets as a function of frequency. On line 4a a spectrum for FSK modulated signals in a direct conversion receiver 1 is shown, a logical "1" data signal having a spectral line at a frequency $f_C$-$\Delta f$, and a logical "0" data signal having a spectral line at a frequency $f_C$+$\Delta f$, $f_C$ being the nominal carrier frequency, and $\Delta f$ being a frequency deviation, e.g. 4 kHz. On line 4b a situation is displayed where the local oscillator frequency $f_L$ is equal to the nominal carrier frequency $f_C$, giving rise to baseband I and Q signals in the quadrature paths 4 and 5 with the same frequency, though with a different phase. On line 4c a corresponding spectrum is shown, showing a single spectral line for mixed down baseband signals I and Q, both for a "1" and a "0" data signal, indicated with $f_1$ and $f_0$ respectively, both at a frequency $\Delta f$, in the given example at 4 kHz. On line 4d a frequency offset situation is displayed, the local oscillator frequency $f_L$ being higher than the nominal carrier frequency $f_C$ by an amount $\delta f$, but still within a range $f_C$-$\Delta f$ to $f_C$+$\Delta f$, $\delta f$ being 2 kHz in the example given. In this situation, the mixed down data signals "1" and "0" appear at $f_1$=6 kHz and $f_0$=2 kHz, i.e. with different frequencies. For a negative offset frequency $\delta f$=$f_L$-$f_C$, the mixed down "1" and "0" data signals appear at a lower and a higher frequency, respectively, such a situation being shown on line 4e. Shown is an offset $\delta f$=-5 kHz, $f_1$ being at 1 kHz, and $f_0$ being at 9 kHz. Also shown on line 4e is a situation where the local oscillator frequency $f_L$ is out-of-range. In an embodiment of the present invention, an out-of-range situation is detected by the out-of-range decision arrangement 47, the filtered data signal fdta being the digital signal dct in case of out-of-range, and the offset frequency detector 17 providing the digital signal dct if the oscillator frequency $f_L$ is in-range.

Fig. 5A shows the digital output signal ofd1 of a prior art offset frequency detector 17 as disclosed in EP 298 484, having a single series arrangement, as a function of time t. The Q-channel baseband signal Q is delayed by a time delay $t_d$, additional delays occurring of +$\pi$/2 and -$\pi$/2 for "0" and "1" data, respectively. I.e. during a "0", the phase difference between the I-signal and the Q-signal is +$\pi$/2, and during a "1", the phase difference between the I-signal and the Q-signal is -π/2. The time delay $t_d$ is taken around $1/(2\Delta f)$, i.e. for $\Delta f = 4$ kHz, $t_d = 125$ μs. The Q-channel delayed signal is multiplied by the I-channel baseband signal I. The digital signal ofd1 is a bipolar signal having a pulse width proportional to the frequency offset δf, up to ½Δf. A correct polarity signal as the control signal ct is obtained by averaging the digital signal ofd1, by means of the filter 18.

Fig. 5B shows the digital output signal ofd2 of the offset frequency detector 17 according to the present invention, having two series arrangements and a subtracting arrangement. The digital signal ofd2 can have three values, a positive value as shown, or zero, or a negative value, depending on the frequency offset δf, i.e. a correct polarity digital signal dct is achieved if the signal ofd2 equates the signal dct. The signal ofd2 has got a considerable higher ripple frequency than the signal ofd1, thus allowing for better loop dynamics.

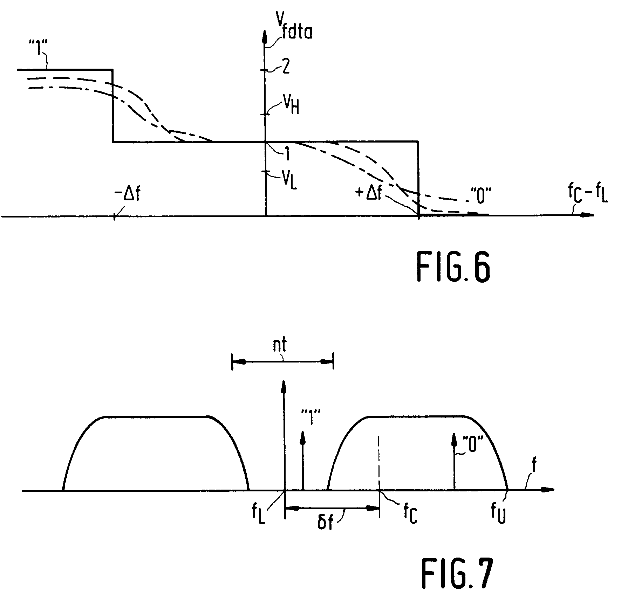

Fig. 6 shows the average value $V_{fdta}$ of the filtered data signal fdta, the filtered data signal fdta being an output signal of the data filter 42, as a function of a frequency deviation of a local oscillator with respect to a carrier frequency of an FSK signal, $f_C - f_L = -\delta f$, in a first out-of-range extension embodiment. The average value $V_{fdta}$ is obtained by feeding the filtered data signal fdta to the RC-filter 90, 91. The out-of-range detection is based upon the insight, the better the condition that the average number of zeroes is equal to the average number of ones, in the data signal dta, is fulfilled, the better the out-of-range detection works. A situation for a paging signal is shown, with a 2 volts signal amplitude for a logical "1" data signal, and a 0 volts signal amplitude for a logical "0" data signal. If the average signal $V_{fdta}$ is out-of-range, i.e. outside the window $V_H$-$V_L$, the out-of-range decision arrangement 47, e.g. a window comparison arrangement, switches the signal fdta as the digital signal dct, whereas for an in-window situation, the signal ofd2 is switched as the digital signal dct. In a practical situation, the channel distance between paging signals is e.g. 25 kHz, thus the present invention achieves quite an out-of-range detection. In figure 7, various signal conditions are shown. A 0% bit-error-rate or BER is indicated with a solid line, a 3% BER with a dashed line, and a 10% BER with a dotted-dashed line. The BER is taken with respect to a zero offset frequency δf. It can thus be seen that the out-of-range detection according to the present invention operates over quite a nominal (zero offset frequency) BER, though for a higher BER out-of-range is detected for a smaller frequency deviation. For weaker signals, i.e. with a higher BER, the out-of-range detection is thus less distinctive. It is to be noticed that for paging applications a 3% BER is allowable.

Figures 7 to 9 show a second out-of-range extension embodiment of the present invention.

Fig. 7 shows a frequency characteristic of the bandpass filters 8 and 12 in an embodiment of the present invention whereby the bandpass filters 8 and 12 implement a frequency gap nt, for a frequency offset $|\delta f| > \Delta f$, Δf being a frequency deviation in an FSK rf input signal with respect to the carrier frequency $f_C$. The gap nt in the frequency characteristic, around the oscillator frequency $f_L$, is chosen such that for δf=0, data "1" and "0" signals just falls outside the gap nt, whereas for the shown frequency offset δf>Δf the "1" data signal falls within the gap nt. The bandpass filters 8 and 12 can also be filters as usually applied in direct conversion receivers, i.e. with a frequency gap just above DC, the frequency gap according to the present invention then being realized by connecting highpass filters 8A and 12A between the limiters 9 and 13 and the offset frequency detector 17. In the latter case, the frequency gap nt is obtained by the combined filtering action of the filters 8 and 8A, and the filters 12 and 12A, respectively. If $|\delta f| > \Delta f$, the filters 8 and 12, or the combined filters 8 and 8A, and 12 and 12A, suppress a signal which would otherwise pull the a.f.c. into the wrong direction, as in the case of a conventional filter in combination with time delay arrangements as the phase shifting arrangements 30 and 37. The effect is that for $|\delta f| > \Delta f + \varepsilon$ the average output signal $V_{av}$ of the offset frequency detector 17 is strongly reduced, ε being the range extension, e.g. ε=0.5Δf. For $\Delta f + \varepsilon < |\delta f| < 2\Delta f$, $V_{av}$ is approximately zero if the number of "1"s is approximately equal to the number of "0"s, on the average, whereas $V_{av}$ is unequal to zero if the number of "1"s is not equal to the number of "0"s, on the average. For $|\delta f| > 2\Delta f$, a correct polarity a.f.c. signal is obtained, $V_{av}$ being an average output signal (not shown) of the offset frequency detector 17.

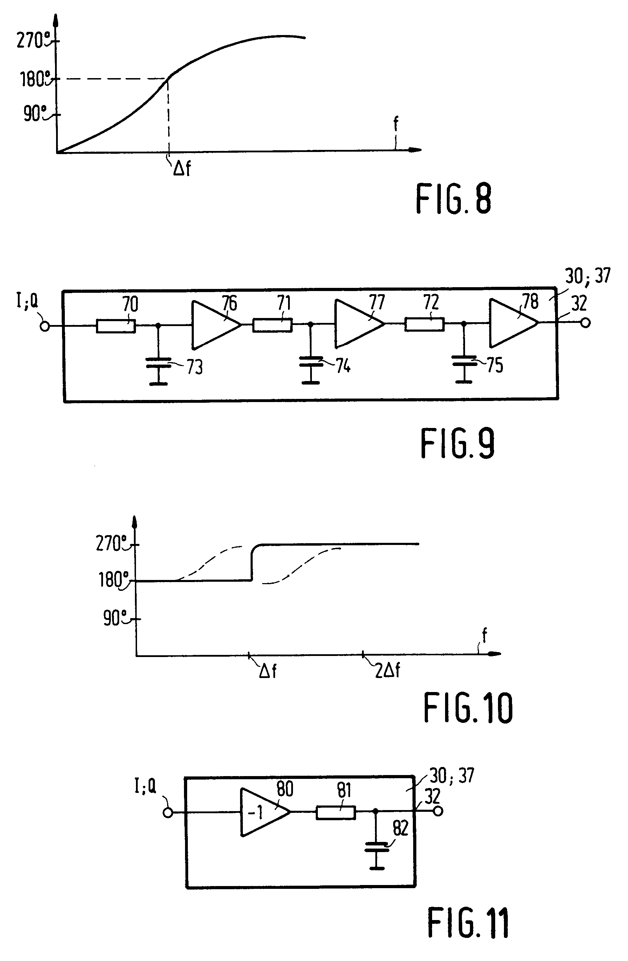

Fig. 8 shows a non-linear phase shifting characteristic for the phase shifting arrangements 30 and 37 in the embodiment of the present invention having the stopband filters as described. Below f=Δf the phase shift increases from 0° to 180°, at f=Δf the phase shifting arrangement 30 and 37 have an 180° phase shift, and for higher frequencies the phase shifting approaches a 270° phase shift. For four RC-filter sections (not shown), the phase shifting approaches a 360° phase shift. In the embodiment given, preferably the limiters 9 and 13 are replaced by a single limiter for limiting the offset frequency detector output signal ofd2.

Fig. 9 shows an embodiment of the phase shifting arrangements 30 and 37 of the present invention, implementing the phase shifting characteristic as shown in figure 9. The arrangements 30 and 37 comprise a cascade of three RC-shifting sections with respective resistors 70, 71, and 72, respective capacitors 73, 74, and 75, and respective opamps 76, 77, and 78. A time constant of the filter sections is $\sqrt{3}/(2\pi\Delta f)$, for three filter sections. The arrangements 30 and 37 may also comprise four RC-shifting sections (not shown).

Figures 10 and 11 show a third out-of-range extension embodiment of the present invention.

Fig. 10 shows a phase shifting characteristic in another embodiment of the present invention, a wide stopband filter around the the oscillator frequency $f_L$ not being necessary. Ideally the characteristic exhibits a 180° phase shift for $f<\Delta f$, and a phase shift of 270° for higher frequencies, but a more gradual phase change will do also, as indicated with a broken line. It holds for $\delta f \neq 0$, that either $|f_0|$ or $|f_1| < \Delta f$, the other one then greater than $\Delta f$. Assuming $|f_0|<\Delta f$ and $|f_1|>\Delta f$, during data "0", the phase shift is 180° with $V_{av}=0$, and during data "1", the phase shift is 270° with $V_{av}$ having the correct polarity. Though an a.f.c. gain reduction occurs due to the fact that during data "0" there is no contribution to $V_{av}$, the advantage is that even for $\Delta f<|\delta f|<2\Delta f$, $f_0$ will not contribute to $V_{av}$, thus ensuring that $V_{av}$ always has the correct polarity. For $|\delta f|>2\Delta f$, both $f_0$ and $f_1$ can contribute to $V_{av}$ with the correct polarity, and without a.f.c. loop gain reduction, for large enough upper cut-off frequencies $f_U$ of the filters.

Fig. 11 shows another embodiment of the phase shifting arrangements 30 and 37, implementing the phase shifting characteristic as shown in figure 10. The arrangements 30 and 37 comprise an inverting amplifier 80, a resistor 81, and a capacitor 82. It has been shown that for various data duty cycles (the number of data "1"s with respect to the number of data "0"s, on the average) and for various 3 dB frequencies of the phase shifting arrangements 30 and 37, e.g. at $0.5\Delta$, $0.67\Delta f$, $\Delta f$, or $2\Delta f$, that a better performance is achieved for an unequal number of "1"s and "0"s, on the average, for larger 3 dB frequencies, the latter giving rise to a smaller $\delta f$ for a.f.c. in-lock.

## Claims

1. A direct conversion receiver (1) comprising a local frequency generating arrangement (14, 15, 16) which is coupled to a pair of quadrature related mixers (7, 11) for mixing down an rf input signal (rf) to quadrature related signals (I, Q), and automatic frequency control means for providing a control signal (ct) for the local frequency generating arrangement (14), the automatic frequency control means, which are coupled to quadrature paths (4, 5), comprising an offset frequency detector (17) for determining a signal (dct) as the control signal (ct), of which an average value is proportional to a frequency offset ($\delta f$) of the local frequency generating arrangement (14, 15, 16) with respect to the rf input signal (rf), whereby the offset frequency detector (17) comprises a first series arrangement of a first phase shifting arrangement (30) and a first multiplication arrangement (31) in a first quadrature path (4), characterised in that the offset frequency detector (17) comprises a second series arrangement of a second phase shifting arrangement (37) and a second multiplication arrangement (38) in a second quadrature path (5), and a subtracting arrangement (40) for subtracting output signals of the first and second multiplication arrangements (31, 38), whereby inputs of the first and second multiplication arrangements (31, 38) are cross-coupled to the second and first quadrature paths (5, 4), and other inputs of the first and second multiplication arrangements (31, 38) are coupled to the first and second quadrature paths via the first and second phase shifting arrangements (30, 37).

2. A direct conversion receiver (1) as claimed in claim 1, wherein the phase shifting arrangement (30; 37) is a shift register and the multiplication arrangement (31; 38) is an exclusive-OR.

3. A direct conversion receiver (1) as claimed in claim 1 or 2, comprising a microcontroller functionally implementing the series arrangements (30, 31; 37, 38) and the subtracting arrangement (40), and digital-to-analog conversion means and/or digital output means for providing the control signal (ct; dct).

4. A direct conversion receiver (1) as claimed in claims 1, 2 or 3, wherein the control signal (dct) is fed to the local frequency generating arrangement via an analog or digital integrator or via an analog or digital low pass filter (18).

5. A direct conversion receiver (1) as claimed in any one of claims 1 to 4, comprising a data demodulation arrangement (19) in parallel with the offset frequency detector (17) for providing data (dta) from the quadrature related baseband signals (I, Q), a data filter (42) for providing filtered data (fdta), and an out-of-range decision arrangement (47) coupled to the data filter (42) via an averaging filter (90, 91), whereby the decision arrangement (47) controls a switching arrangement (45) for switching an output signal (ofd1; ofd2) of the offset frequency detector (17) as the control signal (dct), or the filtered data (fdta) as the control signal (dct).

6. A direct conversion receiver (1) as claimed in claim 5, wherein the decision arrangement (47) is a window comparison arrangement (50, 51, 58), or is a software-based decision arrangement checking data validity, and/or measuring a frequency of a quadrature path signal (I, Q), and/or measuring a frequency of a product of quadrature paths signals (I, Q).

7. A direct conversion receiver as claimed in any one of claims 1 to 4, comprising bandpass filters (8, 12) in the respective quadrature paths, wherein for automatic frequency control out-of-range extension the bandpass filters (8, 12) are stopband filters stopping a band substantially from DC, or wherein for out-of-range extension the direct conversion receiver comprises highpass filters (8A, 12A) coupled to the quadrature paths (4, 5), whereby the combined bandpass (8, 12) and highpass filters (8A, 12A) form stopband filters, and wherein the phase shifting arrangements (30, 37) have a non-linear shifting characteristic approaching a predetermined phase shift with increasing frequency.

8. A direct conversion receiver as claimed in any one of claims 1 to 4, comprising filters in the respective quadrature paths, wherein for automatic frequency control out-of-range extension the phase shifting arrangements (30, 37) have a non-linear phase shifting characteristic changing from a first predetermined phase shift to a second predetermined phase shift with increasing frequency around a frequency deviation of the rf input signal (rf).

**Patentansprüche**

1. Direktumsetzempfänger (1) mit einer Ortsfrequenzerzeugungsanordnung (14, 15, 16), die mit einem Paar quadraturbezogener Mischer (7, 11) gekoppelt ist zum Heruntermischen eines HF-Eingangssignals (rf) zu quadraturbezogenen Signalen (I, Q), und mit ARF-Mitteln zum Schaffen eines Steuersignals (ct) für die Ortsfrequenzerzeugungsanordnung (14), wobei die AFR-Mittel, die mit den Quadraturstrecken (4, 5) gekoppelt sind, einen Offsetfrequenzdetektor (17) aufweisen zum Bestimmen eines Signals (dct) als Steuersignal (ct), dessen mittlerer Wert zu dem Frequenzoffset (δf) der Ortsfrequenzerzeugungsanordnung (14, 15, 16) gegenüber dem HF-Eingangssignal (rf) proportional ist, wobei der Offsetfrequenzdetektor (17) eine erste Reihenschaltung aus einer ersten Phasenschieberanordnung (30) und einer ersten Multiplikationsanordnung (31) in einer ersten Quadraturstrecke (4) aufweist, dadurch gekennzeichnet, dass der Offsetfrequenzdetektor (17) eine zweite Reihenschaltung aus einer zweiten Phasenschieberanordnung (37) und einer zweiten Multiplikationsanordnung (38) in einer zweiten Quadraturstrecke (5) aufweist, sowie eine Subtrahieranordnung (40) zum Subtrahieren von Ausgangssignalen der ersten und der zweiten Multiplikationsanordnung (31, 38), wobei Eingänge der ersten und der zweiten Multiplikationsanordnung (31, 38) mit der zweiten und ersten Quadraturstrecke (5, 4) kreuzgekoppelt sind, und wobei andere Eingänge der ersten und zweiten Multiplikationsanordnung (31, 38) über die erste und die zweite Phasenschieberanordnung (30, 37) mit der ersten und der zweiten Quadraturstrecke gekoppelt sind.

2. Direktumsetzempfänger (1) nach Anspruch 1, wobei die Phasenschieberanodnung (30, 37) ein Schieberegister ist und die Multiplikationsanordnung (31, 38) ein Exklusiv-ODER-Gatter ist.

3. Direktumsetzempfänger (1) nach Anspruch 1 oder 2, mit einem Mikrokontroller, der funktionell die Reihenschaltungen (30, 31; 37, 38) und die Subtrahierschaltung (40) implementiert, und mit Digital-Analog-Wandlermitteln und/oder digitalen Ausgangsmitteln zum Liefern des Steuersignals (ct; dct).

4. Direktumsetzempfänger (1) nach Anspruch 1, 2 oder 3, wobei das Steuersignal (dct) über einen analogen oder digitalen Integrator oder über ein analoges oder digitales Tiefpassfilter (18) der Ortsfrequenzerzeugungsanordnung zugeführt wird.

5. Direktumsetzempfänger (1) nach einem der Ansprüche 1 bis 4, mit einer Datendemodulationsanordnung (19) parallel zu dem Offsetfrequenzdetektor (17) zum Liefern von Daten (dta) aus den quadraturbezogenen Basisbandsignalen (I, Q), mit einem Datenfilter (42) zum Liefern gefilterter Daten (fdta), und mit einer Außerhalb-des-Bereichs-Entscheidungsanordnung (47), die über ein Mittelwertbestimmungsfilter (90, 91) mit dem Datenfilter (42) gekoppelt ist, wobei die Entscheidungsanordnung (47) eine Schaltanordnung (45) steuert zum Schalten eines Ausgangssignals (ofd1; ofd2) des Offsetfrequenzdetektors (17) als das Steuersignal (dct), oder der gefilterten Daten (fdta) als das Steuersignal (dct).

6. Direktumsetzempfänger (1) nach Anspruch 5, wobei die Entscheidungsanordnung (47) eine Fensterentscheidungsanordnung (50, 51, 58) ist oder eine softwarebasierte Entscheidungsanordnung, welche die Gültigkeit der Daten überprüft, und/oder eine Frequenz eines Quadratirstreckensignals (I, Q) misst, und/oder eine Frequenz eines Produktes von Quadraturstreckensignalen (I, Q) misst.

7. Direktumsetzempfänger nach einem der Ansprüche 1 bis 4, mit Bandpassfiltern (8, 12) in den betreffenden Quadraturstrecken, wobei für AFR-Außerhalbdes-Bereichs-Erweiterung die Bandpassfilter (8, 12) Sperrbereichfilter (8, 12) sind, die ein Band im Wesentlichen gegenüber DC sperren, oder wobei für eine Außerhalb-des-Bereichs-Erweiterung der Direktumsetzempfänger Hochpassfilter (8A, 12A) aufweist, die mit den Quadraturstrecken (4, 5) gekoppelt sind, wobei die kombinierten Bandpassfilter (8, 12) und Hochpassfilter (8A, 12A) Sperrbereichfilter bilden, und wobei die Phasenschieberanordnungen (30, 37) eine nicht lineare Schieberkennlinie haben, die bei zunehmender Frequenz einer vorbestimmten Phasendrehung annähert.

8. Direktumsetzempfänger nach einem der Ansprüche 1 bis 4, mit Filtern in den betreffenden Quadraturstrecken, wobei für eine AFR-Außerhalb-des-Bereichs-Erweiterung die Phasenschieberanordnungen (30, 37) eine nicht lineare Phasenschieberkennlinie haben, die bei einer zunehmenden Frequenz um eine Frequenzabweichung des HF-Eingangssignals (rf) von einer ersten vorbestimmten Phasendrehung zu einer zweiten vorbestimmten Phasendrehung sich ändert.

## Revendications

1. Récepteur à conversion directe (1) comportant un dispositif générateur de fréquence local (14, 15, 16) qui est couplé à une paire de mélangeurs apparentés en quadrature pour l'abaissement d'un signal d'entrée radiofréquence (rf) jusqu'à des signaux apparentés en quadrature (I, Q), et des moyens de commande de fréquence automatique pour transmettre un signal de commande (ct) au dispositif générateur de fréquence local (14), les moyens de commande de fréquence automatique qui sont couplés à des trajets en quadrature (4, 5) comportant un détecteur de fréquence de décalage (17) pour déterminer un signal (dct) comme le signal de commande (ct) dont une valeur moyenne est proportionnelle à un décalage de fréquence (δf) du dispositif générateur de fréquence local (14, 15, 16) par rapport au signal d'entrée radiofréquence (rf), cas dans lequel le détecteur de fréquence de décalage (17) comporte un premier montage en série d'un premier dispositif déphaseur (30) et d'un premier dispositif multiplicateur (31) dans un premier trajet en quadrature (4), caractérisé en ce que le détecteur de fréquence de décalage (17) comporte un deuxième montage en série d'un deuxième dispositif déphaseur (37) et d'un deuxième dispositif multiplicateur (38) dans un deuxième trajet en quadrature (5), et un dispositif soustracteur (40) pour soustraire des signaux de sortie des premier et deuxième dispositifs multiplicateurs (31, 38), des entrées des premier et deuxième dispositifs multiplicateurs (31, 38) étant couplées en forme de croix aux deuxième et premier trajets en quadrature (5, 4) et d'autres entrées des premier et deuxième dispositifs multiplicateurs (31, 38) étant couplées aux premier et deuxième trajets en quadrature par l'intermédiaire des premier et deuxième dispositifs déphaseurs (30, 37).

2. Récepteur à conversion directe (1) selon la revendication (1), où le dispositif déphaseur (30; 37) est un registre à décalage et le dispositif multiplicateur (31; 38) est un circuit OU exclusif.

3. Récepteur à conversion directe (1) selon la revendication 1 ou 2, comportant un microcontrôleur utilisant fonctionnellement les montages en série (30, 31; 37, 38) et le dispositif soustracteur (40), et des moyens de conversion numériques-analogiques et des moyens de sortie numériques pour transmettre le signal de commande (ct; dct).

4. Récepteur à conversion directe (1) selon les revendications 1, 2 ou 3, où le signal de commande (dct) est transmis au dispositif générateur de fréquence local par l'intermédiaire d'un intégrateur analogique ou numérique ou par l'intermédiaire d'un filtre passe-bas analogique ou numérique (18).

5. Récepteur à conversion directe (1) selon l'une quelconque des revendications précédentes 1 à 4, comportant un dispositif démodulateur de données (19) en parallèle au détecteur de fréquence de décalage (17) pour fournir des données (dta) en provenance des signaux en bande de base apparentés en quadrature (I, Q), un filtre de données (42) pour fournir des données filtrées (fdta) et un dispositif de décision hors de gamme (47) couplé au filtre de données (42) par l'intermédiaire d'un filtre de moyennage (90, 91), le dispositif de décision (47) commandant un dispositif commutateur (45) pour commuter un signal de sortie (ofd1; ofd2) du détecteur de fréquence de décalage (17) comme le signal de commande (dct), ou les données filtrées (fdta) comme le signal de commande (dct).

6. Récepteur à conversion directe (1) selon la revendication 5, où le dispositif de décision (47) est un dispositif comparateur de fenêtre (50, 51, 58), ou est un dispositif de décision sur la base de logiciel vérifiant la validité de données, et/ou mesurant une fréquence d'un signal (I, Q) du trajet en quadrature, et/ou mesurant une fréquence d'un produit de signaux (I, Q) des trajets en quadrature.

7. Récepteur à conversion directe selon l'une quelconque des revendications précédentes 1 à 4, comportant des filtres passe-bande (8, 12) dans les propres trajets en quadrature où pour l'agrandissement hors de gamme de la commande de fréquence automatique les filtres passe-bande (8, 12) sont des filtres de bande d'arrêt enlevant sensiblement des composants CC d'une bande CC, ou où pour un agrandissement hors de gamme le récepteur à conversion directe comporte des filtres passe-haut (8A, 12A) couplés aux trajets en quadrature (4, 5), les filtres passe-bande (8, 12) et les filtres passe-haut (8A, 12A) constituant des filtres de bande d'arrêt, et où les dispositifs déphaseurs (30, 37) présentent une caractéristique de décalage non linéaire approchant un déphasage prédéterminé avec une fréquence croissante.

8. Récepteur à conversion directe selon l'une quelconque des revendications précédentes 1 à 4, comportant des filtres dans les propres trajets en quadrature, où pour l'agrandissement hors de gamme de la commande de fréquence automatique les dispositifs déphaseurs (30, 37) présentent une caractéristique de déphasage non linéaire changeant d'un premier déphasage prédéterminé en un deuxième déphasage prédéterminé avec une fréquence croissante autour d'un écart de fréquence du signal d'entrée radiofréquence (rf).

FIG.1

FIG.2

FIG.3

FIG.4

FIG.5A

FIG.5B

EP 0 599 414 B1

FIG.6

FIG.7

FIG. 8

FIG. 9

FIG. 10

FIG. 11